(19) Europäisches Patentamt
European Patent Office
Office européen des brevets

(11) **EP 1 043 765 A1**

(12) **EUROPEAN PATENT APPLICATION**
published in accordance with Art. 158(3) EPC

(43) Date of publication:
**11.10.2000 Bulletin 2000/41**

(51) Int. Cl.7: **H01L 21/31**, H01L 21/316, H01L 21/318

(21) Application number: **99947913.2**

(22) Date of filing: **15.10.1999**

(86) International application number:
**PCT/JP99/05692**

(87) International publication number:
**WO 00/26953 (11.05.2000 Gazette 2000/19)**

(84) Designated Contracting States:
**AT BE CH CY DE DK ES FI FR GB GR IE IT LI LU MC NL PT SE**

(30) Priority: **29.10.1998 JP 30837098**

(71) Applicant:
**MATSUSHITA ELECTRIC INDUSTRIAL CO., LTD.
Kadoma-shi, Osaka 571-8501 (JP)**

(72) Inventors:
• **KIDOGUCHI, Isao
  Kawanishi-shi, Hyogo 666-0129 (JP)**

• **ADACHI, Hideto
  Ibaraki-shi, Osaka 567-0044 (JP)**
• **OHNISHI, Toshikazu,
  438, Yamamoto-cho
  Kyoto-shi, Kyoto 604-0933 (JP)**

(74) Representative:
**Grünecker, Kinkeldey,
Stockmair & Schwanhäusser
Anwaltssozietät
Maximilianstrasse 58
80538 München (DE)**

(54) **THIN FILM FORMING METHOD, AND SEMICONDUCTOR LIGHT EMITTING DEVICE MANUFACTURING METHOD**

(57) In depositing a thin film (27) on the surface of a sample (21) through a reaction between a reactive gas changed into plasma by an ECR plasma method on the surface of the sample (21) and an atom or a molecule released from a solid target material (23) through colli-sion of a gas changed into plasma, the thin film (27) is deposited after the surface of the solid target material (23) is cleaned by using the reactive gas changed into plasma.

Fig. 2(a)   Fig. 2(b)   Fig. 2(c)

INITIAL STAGE    FIRST STAGE    SECOND STAGE

EP 1 043 765 A1

## Description

## Technical Field

The present invention relates to a method of forming a thin film of an oxide film, a nitride film or the like of a metal or silicon, and a method of fabricating a semiconductor light emitting device, in particular, a semiconductor laser diode using the method of forming a thin film.

## Background Art

As an insulating film for a semiconductor device, a metal oxide film of titanium oxide ($TiO_2$), aluminum oxide ($Al_2O_3$), tantalum oxide ($TaO_2$), zirconium oxide ($ZrO_2$) or niobium oxide ($Nb_2O_5$) or a silicon oxide film ($SiO_2$) is widely used. In particular, $SiO_2$, $Al_2O_3$ and $TiO_2$, which can be comparatively easily controlled in the refractive index, are utilized as a coating material for a semiconductor light emitting device, particularly, a semiconductor laser diode.

A thin film of $Al_2O_3$, $TiO_3$ or $SiO_2$ is, as is disclosed in Japanese Laid-Open Patent Publication No. 6-97570, conventionally deposited by using a magnetron sputtering system. An oxide having the same composition as the thin film to be deposited is used as a target material, and an argon gas is used as a plasma gas. Although the magnetron sputtering system is inexpensive and easy to deal with, a material with high purity is difficult to obtain because the oxide used as the target material is a compound, and as a result, the deposited oxide film cannot attain high purity.

In order to overcome such a problem, a method of depositing a thin film by using a metal such as Al and Ti or Si as a target material and using electron cyclotron resonance (ECR) plasma has been proposed (for example, described in Japanese Journal of Applied Physics, Vol. 23, p. L534).

The thin film formation method using the ECR plasma is designated as ECR sputtering, in which a high quality thin film can be formed due to supply of a material by sputtering a solid target material and a surface reaction supported effect. Since plasma is generated through electron cyclotron resonance in the ECR sputtering, plasma with low energy and a high density can be obtained. Accordingly, even at a practical deposition rate, the surface of the film to be formed is less damaged by the plasma. Furthermore, the ECR plasma has strong directivity in the plasm stream and a reaction seed is supplied perpendicularly to the surface of a sample on which the thin film is to be formed, and hence, the reaction product can be uniformly deposited on the surface for forming the thin film. Accordingly, a thin film with good flatness can be formed, and therefore, a good reflecting layer can be formed in application to a facet coating of a semiconductor laser.

In the conventional ECR sputtering, however, the depositing rate of a thin film to be deposited is unstable depending upon deposition conditions, which disadvantageously leads to fluctuation of quality of resultant thin films.

## Disclosure of the Invention

An object of the invention is definitely forming a thin film with high adhesion strength at a stable depositing rate by using the ECR sputtering.

The present inventors have examined the cause of the fluctuation of quality of thin films in the ECR sputtering, resulting in finding various problems as follows:

    1) The depositing rate is unstabilized depending upon conditions before depositing a thin film, such as a back pressure (degree of vacuum) attained before generating plasma;
    2) The depositing rate is unstabilized due to contamination, in particular, contamination by an organic substance, on the surface of a sample where a thin film is to be deposited;
    3) The depositing rate is unstabilized in deposition of second and subsequent layers when multiple layers are to be repeatedly deposited;
    4) The adhesion strength of a thin film is so largely degraded due to contamination on the surface of a sample that the formed film peels off.

In order to overcome these problems, in ECR sputtering using a solid target material as a material and using a reactive gas, the surface of the target material or a sample where a thin film is to be formed is previously cleaned by using a plasma gas in this invention.

Specifically, the first thin film formation method of this invention of depositing a thin film on a surface of a sample through a reaction caused on the surface of the sample between a reactive gas changed into plasma by an ECR plasma method and an atom or a molecule released from a solid target material through collision of a gas changed into plasma by the ECR plasma method, comprises a cleaning step of cleaning a surface of the solid target material by using the reactive gas changed into plasma; and a thin film depositing step of depositing the thin film on the surface of the sample after cleaning the surface of the solid target material.

In the first thin film formation method, before depositing the thin film on the surface of the sample, the surface of the solid target material is cleaned by using the reactive gas changed into plasma. Therefore, for example, a surface oxide film produced on the surface of the solid target material before depositing the thin film can be removed. Accordingly, since the thin film is deposited with the surface oxide film removed, there is no factor in inhibiting the release of an atom or a molecule from the solid target material, so that the depositing rate of the thin film can be stabilized and improved. As a result, the formed thin film is precise as well as the throughput of the process can be improved.

In the first thin film formation method, a pressure of the reactive gas in the cleaning step is preferably lower than a pressure of the reactive gas in the thin film depositing step. Thus, the flow of the reactive gas in the cleaning step can be reduced as compared with the flow of the reactive gas in depositing the thin film, and hence, a reaction product is hardly produced on the surface of the solid target material, resulting in definitely cleaning the surface of the target material.

The second thin film formation method of this invention of depositing a thin film on a surface of a sample through a reaction caused on the surface of the sample between a reactive gas changed into plasma by an ECR plasma method and an atom or a molecule released from a solid target material through collision of an inert gas changed into plasma by the ECR plasma method, comprises a cleaning step of cleaning a surface of the solid target material by using the reactive gas or the inert gas changed into plasma; and a thin film depositing step of depositing the thin film on the surface of the sample after cleaning the surface of the solid target material.

In the second thin film formation method, before depositing the thin film on the surface of the sample, the surface of the solid target material is cleaned by using the reactive gas or the inert gas changed into plasma. Therefore, for example, a surface oxide film produced on the surface of the solid target material before depositing the thin film can be removed. Accordingly, since the thin film is deposited with the surface oxide film removed, there is no factor in inhibiting the release of an atom or a molecule from the solid target material, so that the depositing rate of the thin film can be stabilized and improved. As a result, the formed thin film is precise as well as the throughput of the process can be improved.

In the second thin film formation method, in the cleaning step, a partial pressure of the reactive gas is preferably lower than a partial pressure of the reactive gas in the thin film depositing step or the inert gas alone is preferably used. Thus, the flow of the reactive gas in the cleaning step is reduced as compared with the flow of the reactive gas in depositing the thin film, and hence, a reaction product is hardly produced on the solid target material. Also, when the inert gas alone is used, the surface of the solid target material can be more definitely cleaned.

The third thin film formation method of this invention of depositing a thin film on a surface of a sample through a reaction caused on the surface of the sample between a reactive gas changed into plasma by an ECR plasma method and an atom or a molecule released from a solid target material through collision of a gas changed into plasma by the ECR plasma method, comprises a sample cleaning step of cleaning the surface of the sample by using a cleaning gas changed into plasma; a target material cleaning step of cleaning a surface of the solid target material by using the reactive gas or the cleaning gas changed into plasma after cleaning the surface of the sample; and a thin film depositing step of depositing the thin film on the surface of the sample after cleaning the surface of the solid target material.

In the third thin film formation method, in addition to the steps of the first and second thin film formation methods, the surface of the sample is also cleaned, and therefore, an organic substance or the like adhered onto the surface of the sample in processing the sample can be removed. Accordingly, the deposited thin film is difficult to peel off.

In the third thin film formation method, the cleaning gas is preferably an inert gas, and in the target material cleaning step, a partial pressure of the reactive gas is preferably lower than a partial pressure of the reactive gas in the thin film depositing step or the inert gas alone is preferably used. Thus, the surface of the sample and the surface of the solid target material can be definitely cleaned.

In the second or third thin film formation method, the inert gas is preferably an argon gas or a helium gas applicable to a semiconductor fabrication process.

In any of the first through third thin film formation methods, the reactive gas is preferably an oxygen gas and the thin film is preferably an oxide film. Since a thin film having an insulating property can be thus formed, the thin film can be applied to, for example, a coating film of a semiconductor light emitting device.

In any of the first through third thin film formation methods, the reactive gas is preferably a nitrogen gas and the thin film is preferably a nitride film. Since a thin film having a conducting property can be thus formed, it can be applied to a semiconductor device.

In any of the first through third thin film formation methods, the solid target material preferably includes at least one of silicon, titanium, zirconium, hafnium, aluminum, zinc, cerium, tantalum, niobium and strontium. Since oxides of these materials can be comparatively easily controlled in the refractive index, the resultant thin film can be applied to a coating material of a semiconductor light emitting device.

The method of this invention of fabricating a semiconductor light emitting device for depositing a thin film on an emitting facet of the semiconductor light emitting device through a reaction caused on the emitting facet between a reactive gas changed into plasma by an ECR plasma method and an atom or a molecule released from a solid target material through collision of a gas changed into plasma by the ECR plasma method, comprises a device cleaning step of cleaning the emitting facet of the semiconductor light emitting device by using a cleaning gas changed into plasma; a target material cleaning step of cleaning a surface of the solid target material by using the reactive gas or the cleaning gas changed into plasma after cleaning the emitting facet of the semiconductor light emitting device; and a thin film depositing step of depositing the thin film on the emitting facet of the semiconductor light emitting device after cleaning the surface of the solid target material.

In the method of fabricating a semiconductor light emitting device of this invention, before depositing the thin film for coating on the emitting facet of the semiconductor light emitting device, the emitting facet and the surface of the solid target material are cleaned. Therefore, the thin film formed on the emitting facet can be very precise and attain increased adhesion strength, resulting in improving the reliability of the device.

In the method of fabricating a semiconductor light emitting device, the semiconductor light emitting device is preferably a semiconductor laser diode. Thus, the thin film for coating the emitting facet of the laser diode can be improved in its preciseness, prevented from peeling off and reduced in the absorption coefficient. As a result, the semiconductor laser diode can attain high reliability.

**Brief Description of Drawings**

Figure **1** is a sectional view for showing the structure of an ECR sputtering system according to Embodiment 1 and 2 of the invention.

Figures **2(a)** through **2(c)** are schematic diagrams for successively showing procedures in a thin film formation method of Embodiment 1.

Figure **3** is a graph for showing change of a depositing rate and a refractive index of a thin film formed by the thin film formation method of Embodiment 1 in which a cleaning treatment is carried out at the beginning with flow of oxygen reduced.

Figure **4** is a graph for showing change of a depositing rate and a refractive index of a thin film formed by a thin film formation method comparatively described in Embodiment 1 in which flow of oxygen is increased at the beginning.

Figure **5** is a perspective view of a semiconductor laser diode fabricated by a method of fabricating a semiconductor light emitting device according to Embodiment 2 of the invention.

Figures **6(a)** through **6(c)** are schematic diagrams for successively showing procedures in a thin film formation method of Embodiment 2.

Figures **7(a)** and **7(b)** are schematic diagrams for successively showing other procedures in the thin film formation method of Embodiment 2.

Figure **8** is a list of adhesion strength onto a GaAs substrate of thin films formed by using and without using the thin film formation method of Embodiment 2.

**Best Mode for Carrying Out the Invention**

EMBODIMENT 1

Embodiment 1 of the invention will now be described with reference to the accompanying drawings.

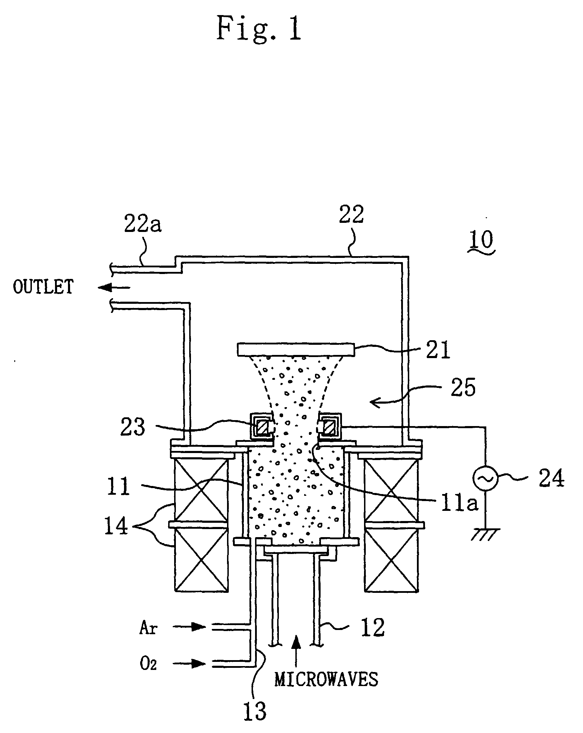

Figure **1** schematically shows the sectional structure of an ECR sputtering system used for realizing a thin film formation method of Embodiment 1. As is shown in Figure **1**, the ECR sputtering system **10** includes a plasma generation chamber **11** having a circular opening **11a** at the uppermost portion and a waveguide **12** for introducing microwaves with a frequency of 2.45 GHz at the lowermost portion; and a thin film deposition chamber (sputter chamber) **22** for housing and holding a sample **21** on which a thin film is to be deposited. Herein, the sample **21** is, for example, a substrate bearing a semiconductor laser diode.

The bottom of the plasma generation chamber **11** is connected to a gas inlet **13** for introducing an argon (Ar) gas serving as a sputtering gas and a cleaning gas, and an oxygen ($O_2$) gas serving as a reactive gas. Furthermore, around the plasma generation chamber **11**, a magnetic coil **14** for generating a magnetic field satisfying an ECR condition is provided.

The bottom of the thin film deposition chamber **22** is connected to the uppermost portion of the plasma generation chamber **11**, a ring-shaped Si target material **23** is disposed on the outer face of the uppermost portion of the plasma generation chamber **11** so as to cover the opening **11a**, and the Si target material **23** is connected to an RF power supply **24** for applying a negative bias voltage. Also, an outlet **22a** for keeping the thin film deposition chamber **22** in vacuum is provided on an upper portion of the side wall of the thin film deposition chamber **22**.

Now, a general method of forming a thin film on the sample **21** by using the ECR sputtering system having the aforementioned structure will be described. As the Si target material, Si bulk is used. This is because Si with high purity (99.999% or more) is easily obtained, and hence, a thin film of silicon dioxide ($SiO_2$) with high purity can be formed.

First, with the microwaves power set to 500 W and with the output value of the RF power supply **24** set to 600 W, an oxygen gas and an argon gas with flow of 30 sccm are introduced into the plasma generation chamber **11** through the gas inlet **13**. At this point, the temperature of the sample **21** is set to room temperature before generating ECR plasma.

Next, a negative bias voltage is applied to the Si target material **23**, so that argon ions included in the plasma can be attracted onto the surface of the Si target material **23** and Si atoms can be released (sputtered) from the Si target material **23**. The released Si atoms together with the oxygen plasma of the reactive gas are introduced onto the surface of the sample **21** as a plasma stream **25**, so as to mutually react on the surface of the sample **21**, resulting in depositing as $SiO_2$ on the surface of the sample **21**, for example, on an emitting facet when a coating is to be formed. The reaction formula of this reaction is

$$Si + O_2 \rightarrow SiO_2.$$

The thin film formation method of this embodiment will now be described with reference to the accompanying drawings.

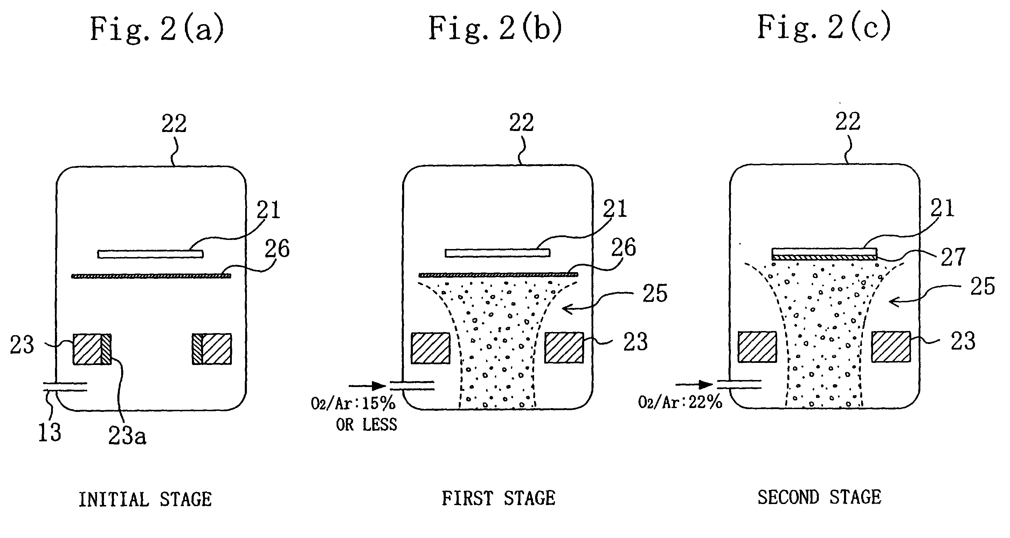

Figures **2(a)** through **2(c)** show successive procedures in the thin film formation method of Embodiment 1. In Figures **2(a)** through **2(c)**, like reference numerals are used to refer to like elements shown in Figure **1**. As is shown in Figure **2(a)**, the thin film deposition chamber **22** of this embodiment is characterized by a shutter **26** for shutting the plasma stream disposed between the sample **21** and the Si target material **23**.

First, at the initial stage shown in Figure **2(a)**, the thin film deposition chamber **22** is evacuated by using a turbo-molecular pump so as to attain a degree of vacuum of $1 \times 10^{-6}$ Torr or less. A surface oxide film **23a** is occasionally formed on the surface of the Si target material **23** through adsorption of oxygen released from the inner wall of the thin film deposition chamber **22** or the surface of the sample **21**. The surface oxide film **23a** is varied in its production condition depending upon the degree of vacuum in the thin film deposition chamber **22**, the operation rate of the system and the like, and hence can be considered to be in an unstable state. When the surface of the Si target material **23** is thus in an unstable state, the conditions, such as a depositing rate, for depositing a thin film on the sample **21** are unavoidably unstable.

Accordingly, in a cleaning process at the first stage shown in Figure **2(b)**, the plasma stream **25** is generated under a condition of a small flow ratio of the oxygen gas to the argon gas, namely, with the flow of the argon gas set to 30 cc/min. and with the flow of the oxygen gas set to 4.5 cc/min. or less, thereby removing the surface oxide film **23a** on the Si target material **23**. At this point, a negative bias voltage is applied to the Si target material **23** by the RF power supply. Also, the shutter **26** is closed so as not to expose the sample **21** to the plasma stream **25**. The flow of the oxygen gas can be zero in the cleaning process.

Next, in a thin film depositing process at the second stage shown in Figure **2(c)**, after the conditions for depositing a thin film of $SiO_2$ are attained by increasing the flow of the oxygen gas, namely, with the flow of the argon gas unchanged but the flow of the oxygen gas changed to 6.5 cc/min., the shutter **26** is opened so as to deposit a thin film **27** on the surface of the sample **21** facing the plasma stream **25**.

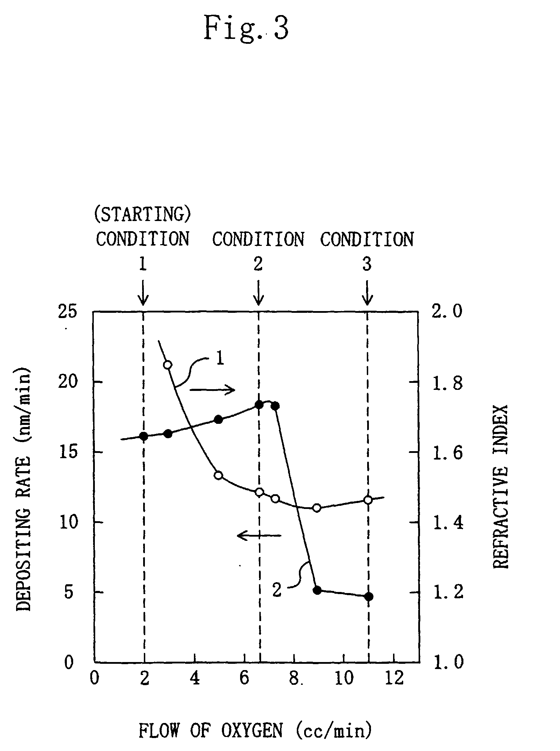

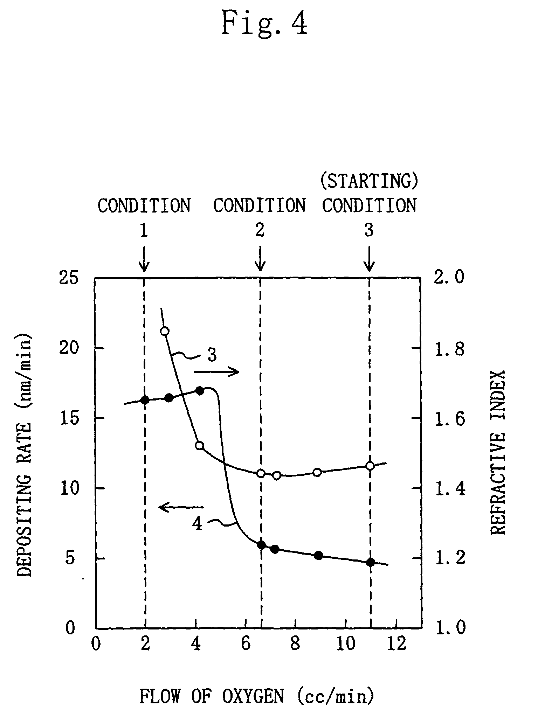

The results of an experience conducted for verifying that the existence of the surface oxide film **23a** can unstabilize the depositing rate are shown in Figures **3** and **4**. Figure **3** shows change of the depositing rate and the refractive index of a thin film formed after conducting the cleaning process with the flow of oxygen reduced at the beginning, and Figure **4** shows, for comparison, change of the depositing rate and the refractive index of a thin film formed after increasing the flow of oxygen at the beginning so that the surface oxide film **23a** can be easily formed. In Figure **3**, the refractive index is shown with a curve **1** and the depositing rate is shown with a curve **2**, and in Figure **4**, the refractive index is shown with a curve **3** and the depositing rate is shown with a curve **4**.

First, in the cleaning process, that is, a starting condition **1** of Figure **3**, with the shutter **26** of Figure **2** closed, with the flow of the oxygen gas set to 2 cc/min., with the flow of the argon gas set to 30 cc/min., and with the output of the RF power supply set to 600 W, the natural oxide film **23a** on the surface of the Si target material **23** is removed by reverse sputtering.

Thereafter, the flow of the oxygen gas is gradually increased and the shutter **26** is opened so that the plasma stream **25** can reach the surface of the sample **21**, thereby depositing the thin film **27** on the surface of the sample **21**. At this point, the refractive index shown with the curve **1** decreases as the oxygen increases and becomes substantially constant to be approximately 1.46 when the flow of the oxygen gas exceeds approximately 6 cc/min. In this case, the refractive index is high in a region where the flow of the oxygen is smaller than 4 cc/min. because the deposited thin film **27** is lack of oxygen arid is in a Si-rich state. Such a film has a large light absorption coefficient and cannot be used as a coating of a semiconductor laser diode. Furthermore, the depositing rate shown with the curve **2** is high when the flow of oxygen is increased up to approximately 7 cc/min. but abruptly decreases when the flow of oxygen exceeds 7 cc/min. This is because the flow of oxygen is so large that the surface of the Si target material **23** is oxidized so as to form a rigid $SiO_2$ having a small sputtering yield thereon. From the viewpoint of productivity, an insulating film is deposited preferably under conditions that the refractive index of the thin film **27** is approximately 1.46 for avoiding light absorption and that the depositing rate is high. In Figure **3**, a condition **2** meets these conditions.

Next, the case where the oxide film is intentionally formed on the surface of the Si target material **23** before depositing a thin film will be described on the basis of Figure **4**.

In a condition **3**, that is, a starting condition of Figure **4**, with the shutter **26** of Figure **2** closed, with the flow of the oxygen gas set to 11 cc/min. and the flow of the argon gas set to 30 cc/min., the surface oxide film **23a** of rigid $SiO_2$ is formed on the surface of the Si target material **23**.

Thereafter, with the flow of the oxygen gas gradually decreased and with the shutter **26** opened, the thin film **27** is deposited on the surface of the sample **21**. The refractive index shown with the curve **3** increases in a region where the flow of the oxygen gas is smaller than approximately 4 cc/min., and the depositing rate shown with the curve **4** increases in a region where the flow of oxygen is smaller than approximately 5 cc/min. At this point, it is noted that the depositing rate is approximately 1/3 of that of Figure **3** even when the flow of oxygen is 6.5 cc/min. equivalently to that in the condition **2** of Figure **3**. This means that the same depositing rate cannot be attained even when the thin film **27** is deposited with the same flow of oxygen, depending upon oxidation of the surface of the Si target material **23**. Also, in the case shown in Figure **4**, a region where the depositing rate is high as well as the refractive index is approximately 1.46 for avoiding light absorption is very small.

As described so far, it is preferred that the surface oxide film **23a** is not formed on the surface of the Si target material **23** at the beginning. Specifically, the surface of the Si target material **23** is first cleaned by generating plasma under a condition of a smaller amount of the oxygen gas, that is, a reactive gas, than in the conditions for depositing a thin film. Thereafter, after the amount of the oxygen gas is increased so as to attain the deposition condition, a desired thin film is deposited on the surface of the sample **21**. In this manner, the precise thin film **27** can be definitely formed.

Although a single-layered film of $SiO_2$ is described in this embodiment, the cleaning process can be carried out on each layer when multiple layers are repeatedly deposited.

Also, the thin film **27** of this embodiment is an insulating film of $SiO_2$, but various precise insulating thin films of aluminum oxide ($Al_2O_3$), titanium oxide ($TiO_2$), zirconium oxide ($ZrO_2$), hafnium oxide ($HfO_2$), tantalum oxide ($TaO_2$), cerium oxide ($CeO_2$), zinc oxide ($ZnO$) and niobium oxide ($Nb_2O_5$) can be formed by using, for example, corresponding metal target materials as the target material, although the flow of the reactive gas such as an oxygen gas is different.

Furthermore, when an alloy target material of an alloy of strontium (Sr) and titanium (Ti) is used as the target material, an insulating thin film of strontium titanium oxide ($SrTiO_2$) can be formed.

Moreover, when Si is used as the target material and a nitrogen ($N_2$) gas is used as the reactive gas, a silicon nitride ($SiN_x$) film can be formed. When Si used as the target material is replaced with Al, an AlN film can be formed, and when it is replaced with Ti, a TiN film can be formed. In such a case, the nitrogen gas works as part of the cleaning gas in the cleaning process.

Furthermore, when a mixed gas of oxygen and nitrogen is used as the reactive gas, a silicon oxidized nitride (SiON) film can be formed when the target material is Si and an aluminum oxidized nitride (AlON) film can be formed when the target material is Al. In either case, an accurate and stable thin film can be formed by conducting the cleaning process of this embodiment before depositing the thin film.

In addition, although the argon gas is used as the sputtering gas and the cleaning gas in this embodiment, a helium gas can be used instead.

EMBODIMENT 2

Embodiment 2 of the invention will now be described with reference to the accompanying drawings.

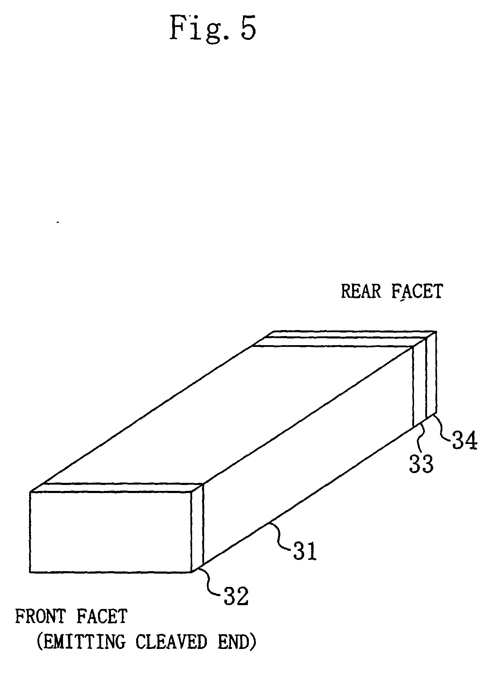

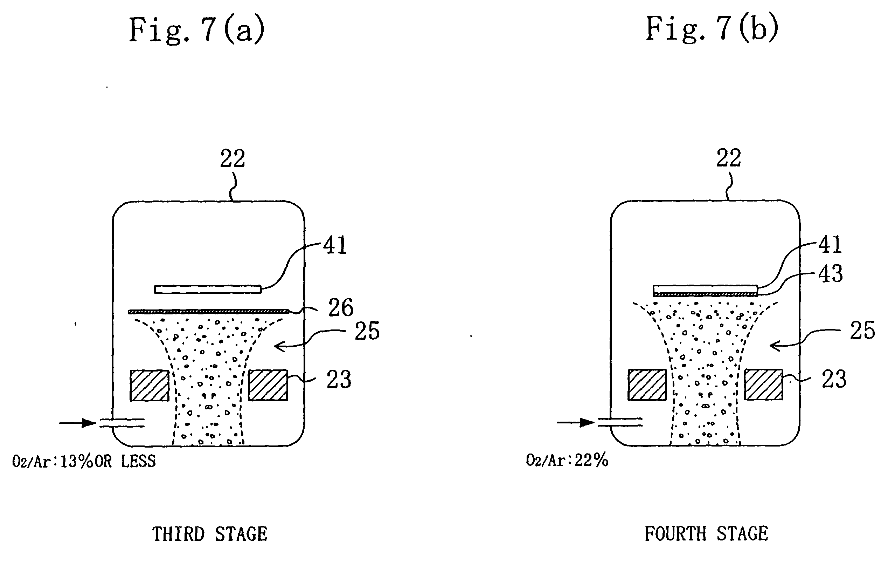

Figure **5** shows a Fabry-Perot semiconductor laser diode fabricated by a method of fabricating a semiconductor light emitting device of Embodiment 2. In the semiconductor laser diode **31** having a resonator along a lengthwise direction as shown in Figure **7**, a first thin film **32** of $SiO_2$ as a front coating is formed on one cleaved end, and a second thin film **33** of $SiO_2$ and a third thin film **34** of $TiO_2$ as a rear coating are stacked on the other cleaved end.

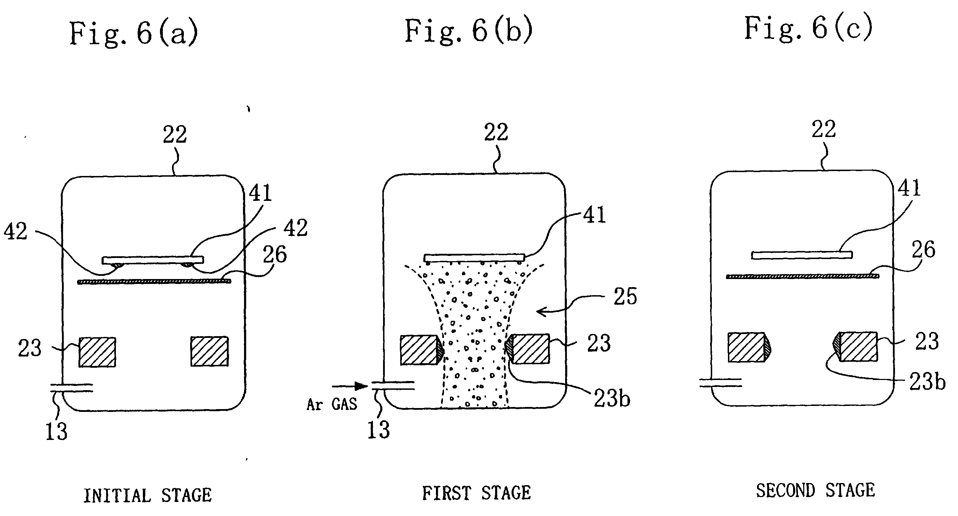

Now, the method of fabricating the semiconductor laser diode **31** having the aforementioned structure, namely, a method of forming the first thin film **32**, the second thin film **33** and the third thin film **34**, will be described. Figures **6(a)** through **6(c)**, **7(a)** and **7(b)** show successive procedures in the method of forming the thin films of this embodiment. Also in Figures **6(a)** through **7(b)**, like reference numerals are used to refer to like elements shown in Figure **2(a)**.

Embodiment 1 describes the cleaning of the surface of the target material. However, an organic substance or the like is occasionally adhered onto the semiconductor laser diode **31** in upstream procedures prior to the formation of the coating. When a thin film is deposited by the ECR sputtering on a sample whose surface for forming the thin film is contaminated, the contaminant is swollen during the deposition of the thin film, so that the thin film can disadvantageously peel off from the surface of the sample in the worst case. In this embodiment, a method of depositing a thin film free from peeling will be described.

First, at the initial stage shown in Figure **6(a)**, the thin film deposition chamber **22** is evacuated by using a turbo-molecular pump to attain a degree of vacuum of $1 \times 10^{-6}$ Torr or less. In this drawing, a reference numeral **41** denotes a substrate on which plural semiconductor laser diodes **31** of Figure **5** are formed with the ends of their resonators exposed through cleavage. Accordingly, organic substances **42** can be adhered onto the exposed ends through a process of the cleavage. When an insulating film of $SiO_2$ or the like is deposited with the organic substances **42** adhered on a surface for forming the thin film, the film can peel off as described above, resulting in largely degrading the device characteristic of the semiconductor laser diode **31**.

Accordingly, in a sample cleaning process at the first stage shown in Figure **6(b)**, an argon gas is introduced into the thin film deposition chamber **22** through the gas inlet **13** at flow of, for example, approximately 30 cc/min., so as to generate the plasma stream **25** under a condition meeting the ECR condition. At this point, the argon gas can include a small amount of an oxygen gas. After sufficiently generating the plasma stream **25**, the shutter **26** is opened, so as to expose the substrate **41** to the plasma stream **25**, thereby removing the organic substances **42** adhered on the substrate **41**.

Next, in the second stage as is shown in Figure **6(c)**, the shutter **26** is closed so that the cleaned substrate cannot be contaminated again. During the removal of the organic substances **42** adhered on the substrate **41**, part of the organic substances **42**, oxygen included in the thin film deposition chamber **22** or the like can be attached to the surface of the Si target material **23** as an attachment **23b**.

Therefore, in a target material cleaning process at the third stage shown in Figure **7(a)**, the plasma stream **25** is generated under a condition of a small flow ratio of an oxygen gas to the argon gas, namely, with the flow of the argon gas set to 30 cc/min. and with the flow of the oxygen gas set to 4.5 cc/min, or less, so as to remove the attachment **23b** adhered on the Si target material **23**. At this point, a negative bias voltage with an output value of 600 W is applied to the Si target material **23** by an RF power supply or a DC power supply.

Next, in a thin film depositing process at the fourth stage shown in Figure **7(b)**, after the condition for depositing a thin film of $SiO_2$ is attained by increasing the flow of the oxygen gas, namely, with the flow of the argon gas unchanged but the flow of the oxygen gas changed to 6.5 cc/min., the shutter **26** is opened, so as to deposit a thin film **43** on the surface of the substrate **41** facing the plasma stream **25**.

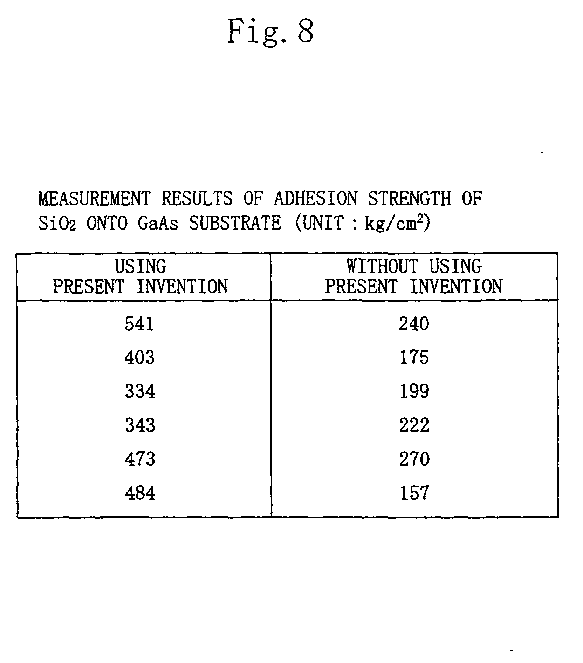

Figure **8** shows adhesion strength onto a GaAs substrate measured in $SiO_2$ thin films each with a thickness of 100 nm formed by using or without using the present method. As is shown in Figure **8**, the number of samples is six in both cases, and it is understood that the thin films formed by the method of this invention are obviously improved in their adhesion strength by approximately 1.5 through 3 times and are difficult to peel off.

Although $SiO_2$ is used as the material for the coating in this embodiment, $SiO_2$ can be replaced with another material such as $Al_2O_3$, $TiO_2$, $SiN_x$, $ZrO_2$, $Nb_2O_5$, ZnO and AlN, or a multi-layered film including any of these materials can be formed. Alternatively, the material can be SiON or AlON.

Furthermore, the Fabry-Perot semiconductor laser diode **31** having a cleaved end as the reflecting edge is exemplified in this embodiment, but the embodiment is applicable to a vertical cavity surface emitting laser diode.

Moreover, application of the thin film formation method of this embodiment is not limited to a semiconductor light emitting device such as a semiconductor laser diode but it is applicable to formation of a thin film in an electronic device, a liquid crystal device, a magnetic resistance (MR, GMR) head or the like. Specifically, the method is expected to be applied to an insulating thin film of $Al_2O_3$ for use in a GMR head.

As the effect of the method, for example, in a semiconductor light emitting device, the preciseness of a thin film to be formed can be improved and the peeling can be prevented because a substrate and a target material are cleaned before forming the thin film. Furthermore, the absorption coefficient of the thin film to be formed can be reduced, resulting in realizing a highly reliable semiconductor light emitting device.

Furthermore, in an MR head or GMR head, the preciseness of a thin film can be improved so as to prevent dielectric breakdown because a head material and a target material are cleaned before forming the thin film of $Al_2O_3$ used for coating the head, resulting in realizing a highly reliable magnetic resistance head.

## Claims

1. A thin film formation method of depositing a thin film on a surface of a sample through a reaction caused on the surface of said sample between a reactive gas changed into plasma by an ECR plasma method and an atom or a molecule released from a solid target material through collision of a gas changed into plasma by the ECR plasma method, comprising:

   a cleaning step of cleaning a surface of said solid target material by using said reactive gas changed into plasma; and
   a thin film depositing step of depositing said thin film on the surface of said sample after cleaning the surface of said solid target material.

2. The thin film formation method of Claim 1, wherein a pressure of said reactive gas in said cleaning step is lower than a pressure of said reactive gas in said thin film depositing step.

3. The thin film formation method of Claim 1, wherein said reactive gas is an oxygen gas and said thin film is an oxide film.

4. The thin film formation method of Claim 1, wherein said reactive gas is a nitrogen gas and said thin film is a nitride film.

5. The thin film formation method of Claim 1, wherein said solid target material includes at least one of silicon, titanium, zirconium, hafnium, aluminum zinc, cerium, tantalum, niobium and strontium.

6. A thin film formation method of depositing a thin film on a surface of a sample through a reaction caused on the surface of said sample between a reactive gas changed into plasma by an ECR plasma method and an atom or a molecule released from a solid target material through collision of an inert gas changed into plasma by the ECR plasma method, comprising:

   a cleaning step of cleaning a surface of said solid target material by using said reactive gas or said inert gas changed into plasma: and
   a thin film depositing step of depositing said thin film on the surface of said sample after cleaning the surface of said solid target material.

7. The thin film formation method of Claim 6, wherein, in said cleaning step, a partial pressure of said reactive gas is lower than a partial pressure of said reactive gas in said thin film depositing step or said inert gas alone is used.

8. The thin film formation method of Claim 6, wherein said inert gas is an argon gas or a helium gas.

9. The thin film formation method of Claim 6, wherein said reactive gas is an oxygen gas and said thin film is an oxide film.

10. The thin film formation method of Claim 6, wherein said reactive gas is a nitrogen gas and said thin film is a nitride film.

11. The thin film formation method of Claim 6, wherein said solid target material includes at least one of silicon, titanium, zirconium, hafnium, aluminum, zinc, cerium, tantalum, niobium and strontium.

12. A thin film formation method of depositing a thin film on a surface of a sample through a reaction caused on the surface of said sample between a reactive gas changed into plasma by an ECR plasma method and an atom or a molecule released from a solid target material through collision of a gas changed into plasma by the ECR plasma method, comprising:

   a sample cleaning step of cleaning the surface of said sample by using a cleaning gas changed into plasma;
   a target material cleaning step of cleaning a surface of said solid target material by using said reactive gas or said cleaning gas changed into plasma after cleaning the surface of said sample; and

a thin film depositing step of depositing said thin film on the surface of said sample after cleaning the surface of said solid target material.

13. The thin film formation method of Claim 12, wherein said cleaning gas is an inert gas, and

   in said target material cleaning step, a partial pressure of said reactive gas is lower than a partial pressure of said reactive gas in said thin film depositing step or said inert gas alone is used.

14. The thin film formation method of Claim 13, wherein said inert gas is an argon gas or a helium gas.

15. The thin film formation method of Claim 12, wherein said reactive gas is an oxygen gas and said thin film is an oxide film.

16. The thin film formation method of Claim 12, wherein said reactive gas is a nitrogen gas and said thin film is a nitride film.

17. The thin film formation method of Claim 12, wherein said solid target material includes at least one of silicon, titanium, zirconium, hafnium, aluminum, zinc, cerium, tantalum, niobium and strontium.

18. A method of fabricating a semiconductor light emitting device for depositing a thin film on an emitting facet of said semiconductor light emitting device through a reaction caused on said emitting facet between a reactive gas changed into plasma by an ECR plasma method and an atom or a molecule released from a solid target material through collision of a gas changed into plasma by the ECR plasma method, comprising:

   a device cleaning step of cleaning said emitting facet of said semiconductor light emitting device by using a cleaning gas changed into plasma;
   a target material cleaning step of cleaning a surface of said solid target material by using said reactive gas or said cleaning gas changed into plasma after cleaning said emitting facet of said semiconductor light emitting device; and
   a thin film depositing step of depositing said thin film on said emitting facet of said semiconductor light emitting device after cleaning the surface of said solid target material.

19. The method of fabricating a semiconductor light emitting device of Claim 18,

**EP 1 043 765 A1**

wherein said semiconductor light emitting device is
a semiconductor laser diode.

# Fig. 1

# Fig. 2(a)

22

21

26

23

13    23a

O₂/Ar:15%
OR LESS

INITIAL STAGE

# Fig. 2(b)

22

21

26

25

23

FIRST STAGE

# Fig. 2(c)

22

21

27

25

23

O₂/Ar:22%

SECOND STAGE

EP 1 043 765 A1

# Fig. 3

# Fig. 4

# Fig. 5

REAR FACET

34
33
31
32

FRONT FACET
(EMITTING CLEAVED END)

Fig. 6(a)

Fig. 6(b)

Fig. 6(c)

INITIAL STAGE

FIRST STAGE

SECOND STAGE

EP 1 043 765 A1

Fig. 7(a)

Fig. 7(b)

22

41

26

25

23

O₂/Ar:13%OR LESS

THIRD STAGE

22

41

43

25

23

O₂/Ar:22%

FOURTH STAGE

# Fig. 8

MEASUREMENT RESULTS OF ADHESION STRENGTH OF
SiO₂ ONTO GaAs SUBSTRATE (UNIT : kg/cm²)

| USING PRESENT INVENTION | WITHOUT USING PRESENT INVENTION |
|---|---|
| 541 | 240 |
| 403 | 175 |
| 334 | 199 |
| 343 | 222 |
| 473 | 270 |
| 484 | 157 |

# INTERNATIONAL SEARCH REPORT

| International application No. |
|---|
| PCT/JP99/05692 |

**A. CLASSIFICATION OF SUBJECT MATTER**
Int.Cl⁷   H01L21/31, H01L21/316, H01L21/318

According to International Patent Classification (IPC) or to both national classification and IPC

**B. FIELDS SEARCHED**

Minimum documentation searched (classification system followed by classification symbols)
Int.Cl⁷   H01L21/31, H01L21/316, H01L21/318

Documentation searched other than minimum documentation to the extent that such documents are included in the fields searched
Jitsuyo Shinan Koho          1926-1996    Toroku Jitsuyo Shinan Koho   1994-1999
Kokai Jitsuyo Shinan Koho    1971-1999    Jitsuyo Shinan Toroku Koho   1996-1999

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP, 9-162496, A (Nippon Telegr. & Teleph. Corp. <NTT>), 20 June, 1997 (20.06.97), Full text,    (Family: none) | 1-19 |
| A | JP, 9-64019, A (Toshiba Corporation), 07 March, 1997 (07.03.97), Full text,    (Family: none) | 1-19 |
| A | JP, 2-34926, A (Matsushita Electric Ind. Co., Ltd.), 05 February, 1990 (05.02.90), Full text,    (Family: none) | 1-19 |
| A | JP, 2-57686, A (Matsushita Electric Ind. Co., Ltd.), 27 February, 1990 (27.02.90), Full text,    (Family: none) | 1-19 |
| A | JP, 60-50167, A (Nippon Telegr. & Teleph. Corp. <NTT>), 19 March, 1985 (19.03.85), Full text,    (Family: none) | 1-19 |

| ☐ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 24 December, 1999 (24.12.99) | 11 January, 2000 (11.01.00) |

| Name and mailing address of the ISA/ | Authorized officer |
|---|---|
| Japanese Patent Office | |
| Facsimile No. | Telephone No. |

Form PCT/ISA/210 (second sheet) (July 1992)